# EUROPEAN PATENT SPECIFICATION

(11) **EP 2 861 049 B1**
(45) Date of publication and mention of the grant of the patent: **09.01.2019**
(21) Application number: 12878329.7
(22) Date of filing: 06.06.2012
(51) Int. Cl.: H05K 13/04

(54) **COMPONENT INSERTION ASSEMBLY DEVICE**
KOMPONENTENEINFÜHRUNGSVORRICHTUNG
DISPOSITIF D'ASSEMBLAGE POUR L'INSERTION D'UN COMPOSANT

(43) Date of publication of application: 15.04.2015
(73) Proprietor: FUJI Corporation, Chiryu Aichi (JP)
(72) Inventor: OHTSUBO, Satoru, Chiryu-shi Aichi 472-8686 (JP)
(74) Representative: Grünecker Patent- und Rechtsanwälte PartG mbB
(86) International application number: PCT/JP2012/064519
(87) International publication number: WO 2013/183123

(56) References cited:
- JP-A- S59 192 483
- JP-A- S60 113 999
- JP-A- S60 113 999
- JP-A- 2007 311 692
- JP-U- H0 634 300
- US-A- 4 944 086

## Description

### Technical Field

The present invention relates to a component insertion assembly device equipped with a chuck device which grasps (clamps) a component and inserts the downward facing protrusions of the component into holes in a target item according to the preamble of claim 1.

### Background Art

As examples of publicly known component insertion assembly devices equipped with this kind of chuck device, items are disclosed in patent literature 1 (Japanese Unexamined Patent Application Publication Number Sho 63-236400) and patent literature 2 (Japanese Unexamined Patent Application Publication Number Hei 6-252594). The chuck devices disclosed in patent literature 1 and 2, as well as being provided with a pair of clamping claws which open and close by compressed air, a pusher (rod) provided in between the pair of clamping claws such that it can move up/down is biased downwards with spring power, and when a component is clamped in the pair of clamping claws, after the component is clamped in the pair of clamping claws in a state with the pusher raised against the spring force by lowering the chuck device a specified amount such that the lower end of the pusher contacts the upper surface of the component, by moving the chuck device above a board, aligning the pins of the components with holes in the board, and opening the clamping claws (clamp release), the pins of the component are inserted into the holes of the board by the pusher which is biased downwards by the spring force. A similar component insertion assembly device equipped with a chuck device according to the preamble of claim 1 is disclosed by JP S60 113999 A, US 4 944 086 A and JP 2007 311692 A.

### Citation List

### Patent Literature

Patent Literature 1: Japanese Unexamined Patent Application Publication Number Sho 63-236400
Patent Literature 2: Japanese Unexamined Patent Application Publication Number Hei 6-252594

### Summary of Invention

### Problem to be Solved by the Invention

With the above configuration, after opening the clamping claws (clamp release) and inserting the pins of the component into the holes in the board using the pusher, the chuck device is raised, but during this raising the clamping claws are opened wider than the width of the component so that the clamping claws do not interfere (collide) with the component. Due to this, when mounting a subsequent component with a narrow gap to an already mounted component, it is possible that the clamping claws will interfere with an adjacent already mounted component during the clamp release movement, leading to a defect. Due to this, it is necessary to leave a gap between components so that the clamping claws do not interfere with an adjacent already mounted component during clamp release movement, which means that it is not possible to support higher density mounting of components (the shrinking of the gaps between components).

Therefore, for the problem to be solved by this invention, what is proposed is a component insertion assembly device equipped with a chuck device which can mount with a narrow gap between components.

### Means for Solving the Problem

In order to solve the above problem, the present invention discloses a component insertion assembly device according to claim 1. The component insertion assembly device is equipped with a chuck device for grasping a component and inserting the downward facing protrusions of the component into holes in a target item; wherein the chuck device comprises a clamping section to clamp the downward facing protrusions of the component, a pusher section for pushing the downward facing protrusions of the component into holes in the target item, and two air cylinder sections for moving the clamping section and the pusher section respectively; wherein the component insertion assembly device comprises a moving mechanism for moving the chuck device in the horizontal direction and up/down direction, and a control device for controlling the two air cylinder sections to control the push movement of the pusher section and the clamp movement/clamp release movement of the clamping section as well as controlling the moving mechanism to control the movement of the chuck device in the horizontal direction and up/down direction; wherein the opening amount during clamp release movement of the clamping section is set so that interference does not occur with an adjacent already mounted component; wherein the control device, after downward facing protrusions of the component are clamped by the clamping section and the lower end of the protrusions are inserted into holes in the target item, performs clamp release movement of the clamping section and then, by moving the chuck device in a direction away from the component which is a direction perpendicular to the clamp release movement direction of the clamping section, moves the clamping section to a position which does not interfere with the component while the clamping section is raised, and after moving the pusher section to a position above the component, and after inserting the downward facing protrusions of the component into holes in the target item by performing downwards push movement on the pusher section, raises the clamping section and pusher section to a position higher than the component by raising the chuck device.

That is, the present invention, when performing clamp release movement, sets the opening amount of the clamping section to the minimum amount or close to it so that the clamping section does not interfere with adjacent already mounted components, and, by moving the chuck device after clamp release movement in a direction away from the component in a direction which is perpendicular to the clamp release movement direction of the clamping section, after moving the clamping section to a position which does not interfere with the component when raising the clamping section, and after performing push movement of the pusher section to insert the downward facing protrusions of the component into the holes in the target item, the chuck device is raised, which means that it can be avoided that the clamping section interferes with an adjacent already mounted component during clamp release movement even when mounting a subsequent component with a narrow gap to an already mounted component, furthermore, push movement can be performed with the opening amount of the clamping section being small, which means that it can be avoided that the clamping section interferes with an adjacent already mounted component during push movement. By this, it is possible to mount with a narrow gap between components and higher density mounting of components (the shrinking of the gaps between components) can be supported.

In this case, it is good if the clamping section of the chuck device is formed in an L-shape with the lower portion thereof bent towards the pusher section side, and if the pusher section is positioned in a location separated from the position of the end of the clamping section in a perpendicular direction to the clamp release movement direction of the clamping section. If the clamping section is formed in an L-shape with the lower portion thereof bent towards the pusher section side in this way, it is possible to clamp the downward facing protrusions of the component by moving only the lower portion of the clamping section which is bent towards the pusher section side during clamp movement, and it is possible to clamp the protrusions of even relatively small components.

The present invention may be applied to a component mounter, an component insertion machine, an assembly machine and so on, but when it is applied to a component mounter, it is good for the chuck device to be held on the mounting head provided on a moving mechanism such that the chuck device can be interchanged with a suction nozzle for picking up components, and to supply air pressure to the two air cylinder sections through the air supply route of the mounting head. By doing this, the chuck device can be held on the mounting head of the component mounter and used only for production in which a chuck device is required, and for production in which a chuck device is not required, the chuck device can be removed from the mounting head of the component mounter and be replaced with a suction nozzle to be used, so the same mounting head can be used efficiently for chuck devices and suction nozzles. Also, because both the clamping section and pusher section can be moved by switching the air pressure supplied to the two air cylinder sections of the chuck device using the air pressure switching function of the air pressure provided on the component mounter side which is used to switch between the component pickup operation and release operation of suction nozzles, it is not necessary to provide the chuck device itself with a dedicated air pressure switching function, which has the merit of making the configuration of the chuck device simpler.

With respect to the two air cylinder sections supplied through the air supply route of the mounting head, the clamping section is moved in the clamp direction with the pusher section held in the push release position when negative pressure is supplied, the clamping section is moved in the clamp release direction when atmospheric pressure is supplied, and the pusher section is moved in the push direction when positive pressure is supplied. In this manner it is possible to control the clamp movement/release movement of the clamping section and the push movement of the pusher section using the air pressure switching function which is used to control the component pickup operation/release operation of suction nozzles, and control of each operation of the chuck device is also easy.

### Brief Description of Drawings

[FIG. 1] FIG. 1 is a view with some section cut out showing the chuck device being held on the mounting head of the component mounter of an embodiment of the present invention.
[FIG. 2] FIG. 2 (a) is a cross section front view of the chuck device during clamp movement; FIG. 2 (b) is a cross section front view of the chuck device during clamp release movement.
[FIG. 3] FIG. 3 is a cross section side view of the chuck device showing the state during movement with the leads of a component clamped by the clamping claws.
[FIG. 4] FIG. 4 is a cross section side view of the chuck device showing the state during insertion of the ends of the leads clamped by the clamping claws into holes in the board.
[FIG. 5] FIG. 5 is a cross section side view of the chuck device showing the state when the chuck device is moved horizontally in a direction perpendicular to the clamp release movement direction after clamp release movement.
[FIG. 6] FIG. 6 is a cross section side view of the chuck device showing the state when the push movement downwards of the pusher section has been performed and the component leads have been inserted into the board.
[FIG. 7] FIG. 7 is a cross section side view of the chuck device showing the state when the chuck device has been raised after push movement.
[FIG. 8] FIG. 8 is a block diagram showing the configuration of control items of the component mounter.
[FIG. 9] FIG. 9 is a block chart showing the processing flow of the component lead insertion assembly control program.

### Description of Embodiments

The following describes a specific embodiment for carrying out the present invention using a component mounter.

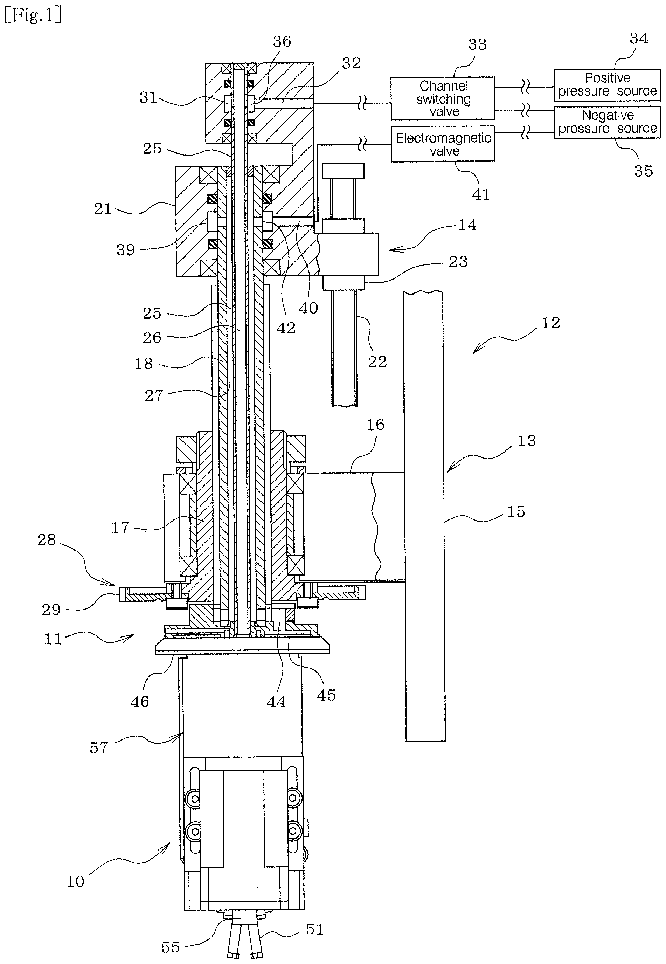

First, the following describes the configuration of the component mounter mounting head 11 side on which chuck device 10 is removably held based on FIG. 1.

Moving mechanism 12 which supports mounting head 11 comprises XY direction moving mechanism 13 for moving in the X direction (board conveyance direction) and Y direction (direction perpendicular to the board conveyance direction) and Z direction moving mechanism 14 for moving in the Z direction (up/down direction).

XY direction moving mechanism 13 is configured such that Y slide 15 which moves in the Y direction is provided on the X slide (not shown in the figure) which moves in the X direction, and cylinder rotation member 17 is supported rotatably around Z axis section 18 (centered around air supply pipe 25 which is mentioned below) on Y slide 15 via supporting member 16. Hollow Z axis section 18 is spline fitted such that it is movable in the Z direction and mounting head 11 is provided concentrically at the lower end of Z axis section 18 inside cylinder rotation member 17.

Z axis section 18 protrudes from the upper side of cylinder rotation member 17 and the upper end of the Z axis section 18 is rotatably attached to raising/lowering member 21 of Z direction moving mechanism 14. Z direction moving mechanism 14 comprises ball screw 22 which is rotated by a Z axis motor (not shown in the figure) and nut member 23 which moves in the Z direction by the rotation of the ball screw 22, and raising/lowering member 21 is fixed to the nut member 23.

Air supply pipe 25 is provided concentrically inside hollow Z axis section 18, and the internal space of air supply pipe 25 is used as air supply route 26 jointly for positive pressure/atmospheric pressure/negative pressure, while the circular gap formed between the outer surface of the air supply pipe 25 and the inner surface of Z axis section 18 is used as air supply route 27 dedicated for negative pressure. The upper end section of air supply pipe 25 is rotatably supported on raising/lowering member 21 of Z direction moving mechanism 14, and air supply pipe 25 and Z axis section 18 are moved as one in the Z direction by the Z direction movement of raising/lowering member 21.

Gear 29 of head rotating device 28 is provided on the outer section of cylinder rotation member 17, and by rotating this gear 29 by a motor (not shown in the figure), cylinder rotation member 17 is rotated such that Z axis section 18, air supply pipe 25, and mounting head 11 are rotated as one with it.

On raising/lowering member 21, as well as air inlet groove 31 being formed in a circle along the outer surface of air supply pipe 25, air inlet port 32 extending from the outer surface of raising/lowering member 21 to air inlet groove 31 is formed, and the configuration is such that positive pressure source 34, negative pressure source 35, and atmospheric pressure release outlet (not shown in the figure) can be selectively connected to air inlet port 32 via channel switching valve 33. Connection hole 36 passing through the diameter direction is formed in the section opposite air inlet groove 31 of the circle of air supply pipe 25, and positive pressure, atmospheric pressure, or negative pressure air introduced into air inlet port 32 via channel switching valve 33 from positive pressure source 34 or negative pressure source 35 or the atmospheric pressure release outlet is supplied into air supply route 26 jointly for positive pressure/atmospheric pressure/negative pressure inside air supply pipe 25 from air inlet groove 31 through connection hole 36. Here, positive pressure source 34 is configured from an item such as a blower or compressor and negative pressure source 35 is configured from an item such as a negative pressure pump.

Also, on raising/lowering member 21, as well as air inlet groove 39 being formed in a circle along the outer surface of Z axis section 18, air inlet port 40 extending from the outer surface of raising/lowering member 21 to air inlet groove 39 is formed, and negative pressure source 35 is connected to air inlet port 40 via electromagnetic valve 41. Electromagnetic valve 41 can be switched between a position to introduce negative pressure supplied from negative pressure source 35 into air inlet port 40 and a position to open air inlet port 40 to the atmosphere.

Connection hole 42 passing through the diameter direction is formed in the section exposed to air inlet groove 39 of the circle of Z axis section 18, and negative pressure introduced into air inlet port 40 via electromagnetic valve 41 from negative pressure source 35 is supplied into air supply route 27 inside Z axis section 18 from air inlet groove 39 through connection hole 42.

In mounting head 11 attached to the lower end of Z axis section 18, negative pressure chamber for pickup 45 connected via air supply route 27 and connection passage 44 is formed such that the lower surface has an opening, and the upper surface of chuck device 10 (or the upper surface of a pickup nozzle) is picked up and held by the negative pressure supplied to negative pressure chamber for pickup 45.

When chuck device 10 is to be held on mounting head 11, as well as mounting head 11 being moved above chuck device 10 by moving mechanism 12 of the component mounter, electromagnetic valve 41 of negative pressure source 35 is switched to the negative pressure introduction position, and the lower surface of mounting head 11 is contacted against the upper surface of chuck device 10 while negative pressure is supplied to negative pressure chamber for pickup 45 of mounting head 11 from negative pressure source 35 through air supply route 27. By this, chuck device 10 is picked up and held on the lower surface of mounting head 11 by the negative pressure. Conversely, when chuck device 10 is to be removed from mounting head 11, electromagnetic valve 41 is switched to the atmospheric pressure introduction position, and pickup of chuck device 10 is release by the introduction of atmospheric pressure into negative pressure chamber for pickup 45.

On the other hand, the lower end of air supply route 26 jointly for positive pressure/atmospheric pressure/negative pressure inside air supply pipe 25 opens on the lower surface of mounting head 11, and positive pressure/atmospheric pressure/negative pressure air is supplied to the air supply entrance (not shown in the figure) of the upper wall of chuck device 10 (or a pickup nozzle) from the lower end of air supply route 26.

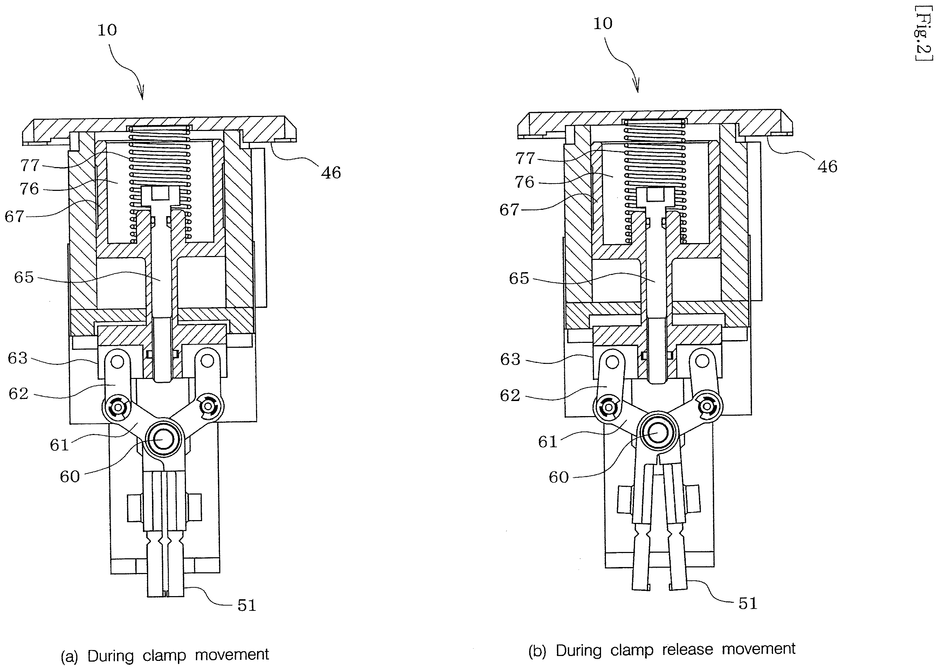

Next, the configuration of chuck device 10 is described using FIG. 2 to FIG. 7. Chuck device 10 comprises a pair of clamping claws 51 (clamping section) for clamping leads 52 (protrusions) of component 50, pusher section 55 for pushing the leads 52 of component 50 into holes 54 of board 53 (target item), air cylinder section 57 for clamping which moves clamping claws 51 and air cylinder section 58 for pushing which moves pusher section 55.

Pair of clamping claws 51 are attached with axis 60 as a fulcrum such that they can be opened/closed by being rotated, and arm sections 61 which protrude towards each other are formed as one body on the upper section on each clamping claw 51. By this, when arm sections 61 are rotated downwards, clamping claws 51 are rotated in the open direction (clamp release direction).

Each tip section of arm section 61 of clamping claw 51 moves up and down as one body with raising/lowering member 63 and rod 65 via link members 62. Piston 67 of air cylinder section 57 for clamping is fixed to the upper section of this rod 65.

Pressure chamber 76 is formed above piston 67 of air cylinder section 57 for clamping, and spring 77 for biasing piston 67 in the downward direction (clamp release direction) is stored in this pressure chamber 76. An air supply entrance (not shown in the figure) which connects to air supply route 26 jointly for positive pressure/atmospheric pressure/negative pressure on the mounting head 11 side is formed on the ceiling of pressure chamber 76 of air cylinder section 57 for clamping, and positive pressure/atmospheric pressure/negative pressure air from air supply route 26 jointly for positive pressure/atmospheric pressure/negative pressure on the mounting head 11 side is supplied into pressure chamber 76 through the air supply entrance on the upper surface of chuck device 10.

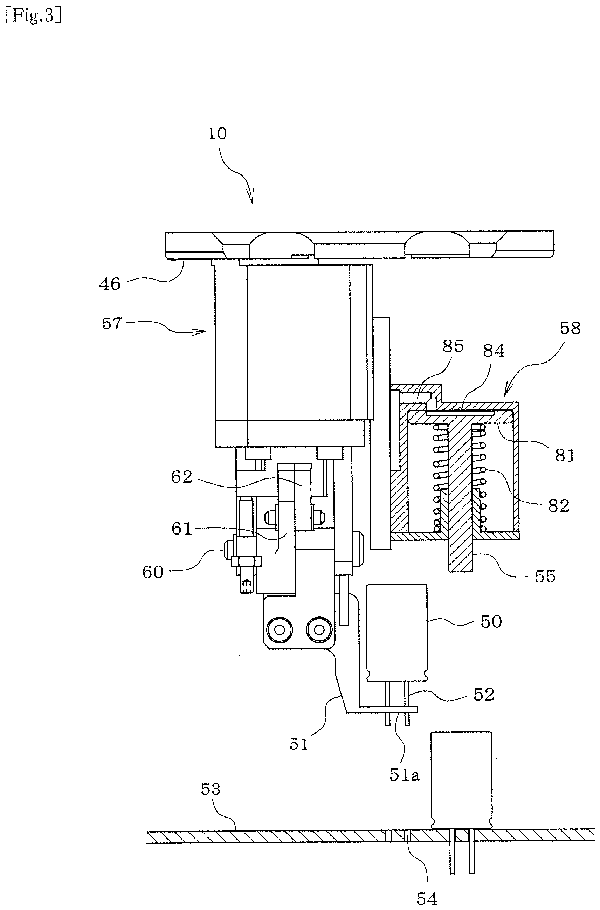

As shown in FIG. 3, the lower section of the pair of clamping claws 51 are each formed in an L-shape bent towards pusher section 55, with claw tip section 51a extending towards pusher 55 virtually horizontally. The opening amount for the clamp release movement of clamping claws 51 is set to be the minimum amount such that interference does not occur with adjacent already mounted components, or an amount slightly larger than that. Also, the positional relationship between clamping claws 51 and pusher section 55 is that pusher section 55 is provided in a position separated by just a specified amount (for example, an amount slightly smaller than the width of component 50 to be clamped or an amount about the same as the width of component 50) from the position of the tip of claw tip section 51a of clamping claws 51 in the direction perpendicular to the clamp release movement direction of the clamping claws 51.

When performing clamp movement to sandwich leads 52 of component 50 with clamping claws 51 of chuck device 10, channel switching valve 33 is switched to the negative pressure source 35 side and negative pressure is supplied to pressure chamber 76 of air cylinder section 57 for clamping from air supply route 26 jointly for positive pressure/atmospheric pressure/negative pressure on the mounting head 11 side. By this, as shown in FIG. 2 (a), piston 67 is sucked up against the spring force of spring 77, rod 65 is pulled up, and raising/lowering member 63 is pulled up as one body with this. By this pulling up movement of raising/lowering member 63, arm section 61 of the pair of clamping claws 51 are pulled up with axis 60 as a fulcrum via link members 62, by which the pair of clamping claws 51 are rotated in the closing direction (clamp direction) with axis 60 as a fulcrum.

When performing clamp release movement, channel switching valve 33 is switched to the atmospheric pressure release outlet side and the air pressure supplied to air supply route 26 jointly for positive pressure/atmospheric pressure/negative pressure on the mounting head 11 side switches from negative pressure to atmospheric pressure. By this, atmospheric pressure is supplied to pressure chamber 76 of air cylinder section 57 for clamping from air supply route 26, and because the negative pressure suction which until that point was sucking up piston 67 is no longer present, as shown in FIG. 2 (b), piston 67 is pushed down as one body with rod 65 by the spring force of spring 77, and raising/lowering member 63 is pushed down. By this pushing down movement of raising/lowering member 63, arm section 61 of the pair of clamping claws 51 are pushed down with axis 60 as a fulcrum via link members 62, and the pair of clamping claws 51 are rotated as one body with this in the opening direction (clamp release direction) with axis 60 as a fulcrum. As given above, the opening amount of clamping claws 51 during clamp release movement is set to be the minimum amount such that interference does not occur with adjacent already mounted components, or an amount slightly larger than that.

Next, the configuration of air cylinder section 58 for pushing which moves pusher section 55 is described using FIG. 3 to FIG. 7.

Piston 81 of air cylinder section 58 for pushing is biased upwards (in the push release direction) by the spring force of spring 82 which is positioned underneath thereof. Pusher section 55 (rod) is provided protruding downwards on the lower center section of piston 81.

Pressure chamber 84 is formed above piston 81 of air cylinder section 58 for pushing. A connection passage (not shown in the figure) which connects the air supply entrance (not shown in the figure) of the upper surface of chuck device 10 and air inlet 85 on the ceiling of pressure chamber 84 is provided, and positive pressure/atmospheric pressure/negative pressure air supplied through air supply route 26 jointly for positive pressure/atmospheric pressure/negative pressure on the mounting head 11 side is introduced into pressure chamber 84 through this connection passage.

The air supply entrance on the upper surface of chuck device 10 is the shared air supply entrance for supplying air to both pressure chambers 76 and 84 of air cylinder section 57 for clamping and air cylinder section 58 for pushing. Due to this, at the same time as when atmospheric pressure is introduced into pressure chamber 76 of air cylinder section 57 for clamping during clamp release movement of clamping claws 51, atmospheric pressure is also introduced into pressure chamber 84 of air cylinder section 58 for pushing, however, piston 81 of air cylinder section 58 for pushing is held in the upper limit position and pusher section 55 is also held in the upper limit position by the spring force of spring 82.

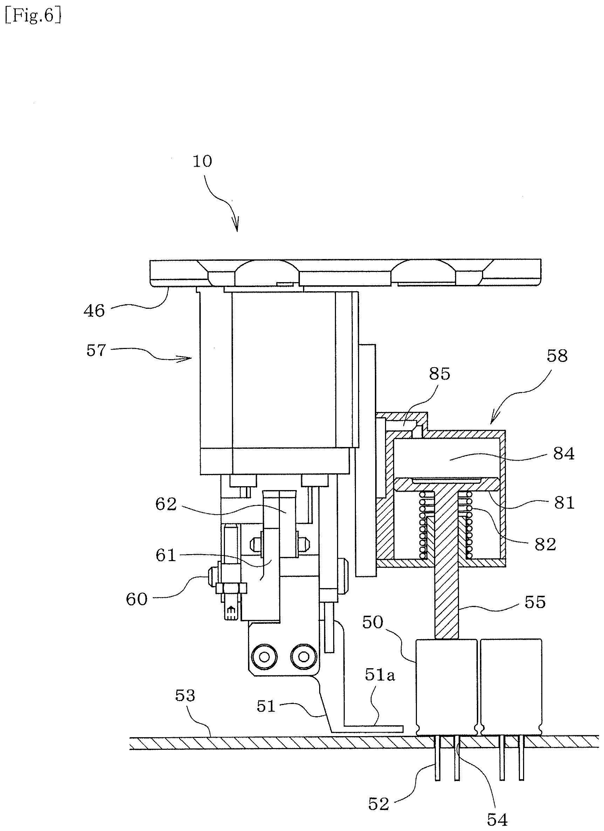

After that, when performing the push movement of pusher section 55, channel switching valve 33 is switched to the positive pressure source 34 side, and the air pressure supplied to air supply route 26 jointly for positive pressure/atmospheric pressure/negative pressure on the mounting head 11 side switches to positive pressure. By this, positive pressure air from air supply route 26 jointly for positive pressure/atmospheric pressure/negative pressure on the mounting head 11 side is supplied into pressure chamber 84 of air cylinder section 58 for pushing. By this, as shown in FIG. 6, piston 81 of air cylinder section 58 for pushing is pushed down against the spring force of spring 82, by which pusher section 55 is lowered and leads 52 of component 50 are inserted into holes 54 of board 53.

During this push operation of pusher section 55, positive pressure air is also supplied to pressure chamber 76 of air cylinder section 57 for clamping, but because the positive air pressure pushes piston 67 in the downwards direction (clamp release direction) in the same way as the spring force of spring 77, clamping claws 51 are held in the clamp release state.

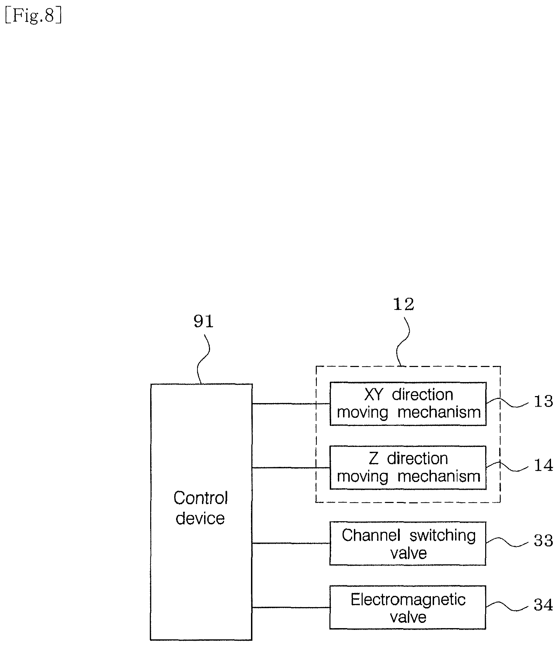

Control device 91 (refer to FIG. 8) of the component mounter, as well as controlling the push movement of pusher section 55 and the clamp movement/clamp release movement of clamping claws 51 by switching channel switching valve 33 to switch the air pressure supplied to the two air cylinder sections 57 and 58 of chuck device 10, controls moving mechanism 12 (XY direction moving mechanism 13 and Z direction moving mechanism 14) to control the horizontal (XY direction) and vertical (Z direction) movement of chuck device 10.

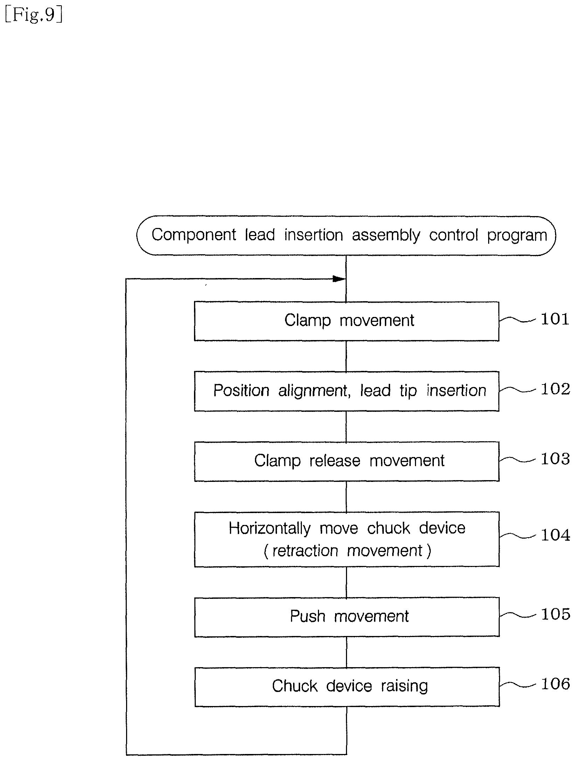

Movement to clamp leads 52 of component 50 and insert them into holes 54 of board 53 is controlled by control device 91 according to the component lead insertion assembly control program of FIG. 9. Described below is the processing of the component lead insertion assembly control program of FIG. 9.

First, in step 101, channel switching valve 33 is switched to the negative pressure source 35 side, and by supplying negative pressure to pressure chamber 76 of air cylinder section 57 for clamping, as shown in FIG. 3, leads 52 of component 50 are clamped with clamping claws 51 and moved directly above holes 54 of board 53.

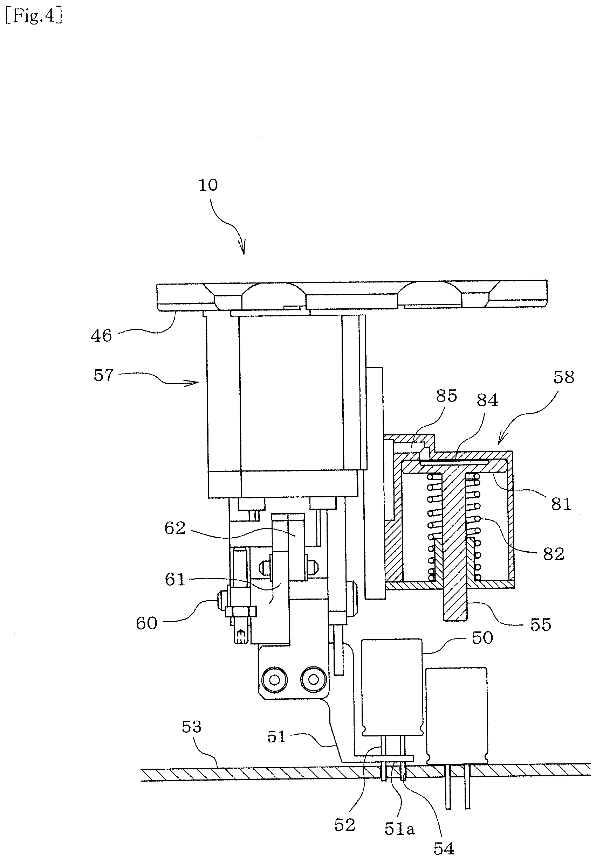

After that, continuing to step 102, by controlling moving mechanism 12 such that chuck device 10 is moved suitably in the horizontal direction (XY direction) and vertical direction (Z direction), as shown in FIG. 4, the tips of leads 52 of component 50 which were clamped by clamping claws 51 of chuck device 10 are aligned with holes 54 of board 53 and the tips of leads 52 are inserted into holes 54 of board 53.

After that, continuing to step 103, channel switching valve 33 is switched to the atmospheric pressure release outlet side, and by supplying atmospheric pressure to pressure chamber 76 of air cylinder section 57 for clamping, clamp release movement is performed for clamping claws 51 of chuck device 10 and the clamping of leads 52 of component 50 is released. The opening amount of clamping claws 51 during this clamp release movement is set to be the minimum amount such that interference does not occur with adjacent already mounted components, or an amount slightly larger than that.

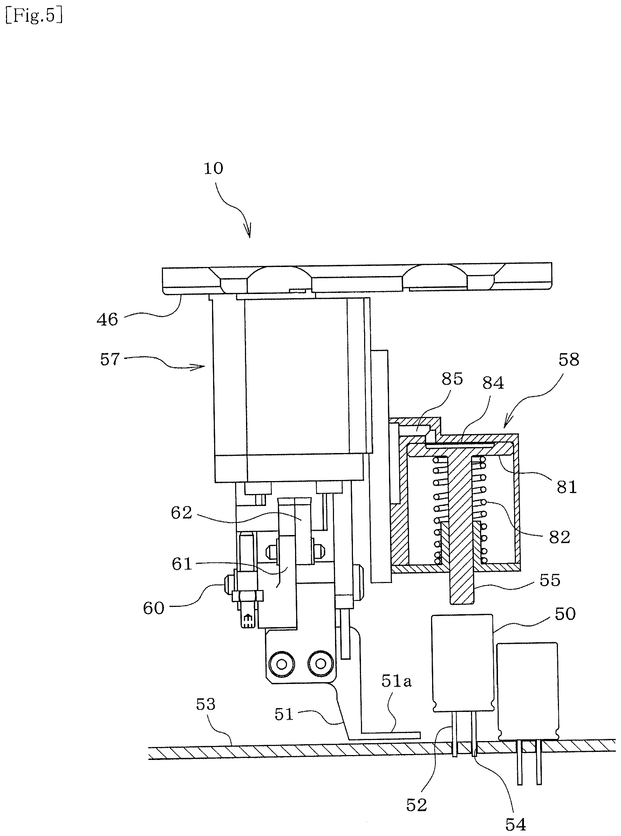

After that, continuing to step 104, moving mechanism 12 is controlled such that, as shown in FIG. 5, by performing horizontal movement (retraction movement) on moving chuck device 10 in a direction away from component 50 in a direction perpendicular to the clamp release movement direction of clamping claws 51, pusher section 55 is horizontally moved to a position directly above component 50 and clamping claws 51 are horizontally moved to a retraction position at which interference with component 50 does not occur during raising.

After that, continuing to step 105, channel switching valve 33 is switched to the positive pressure source 34 side, and by supplying positive pressure to pressure chamber 84 of air cylinder section 58 for pushing, as shown in FIG. 6, pusher section 55 is lowered and leads 52 of component 50 are inserted into holes 54 of board 53.

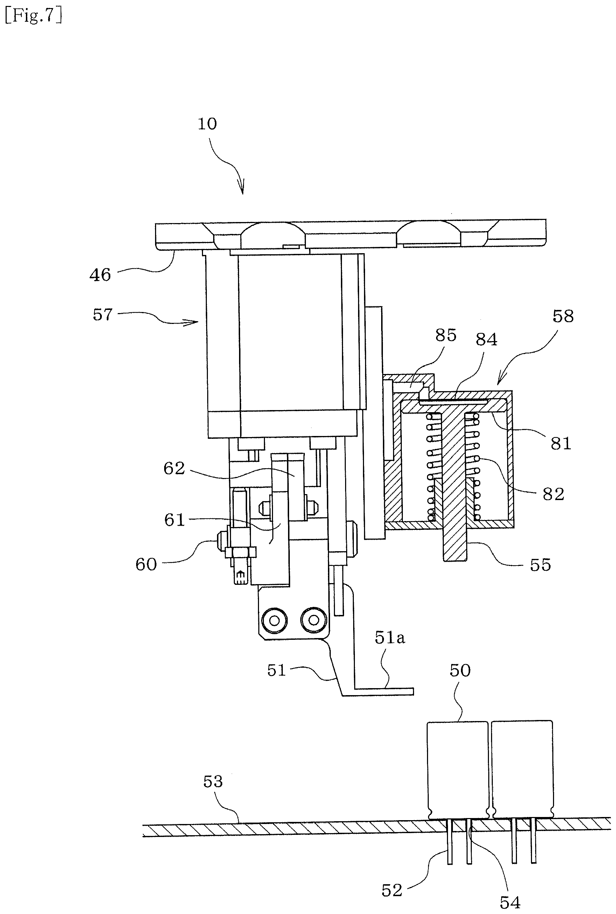

After that, continuing to step 106, moving mechanism 12 is controlled such that, as shown in FIG. 7, chuck device 10 is raised and claws 51 and pusher section 55 are raised to a position higher than component 50 on board 53. Here, because clamping claws 51 have been retracted to a position in which interference does not occur with component 50 by the retraction movement of the above step 104, the interference of clamping claws 51 with component 50 during the raising of chuck device 10 is avoided.

During raising of chuck device 10, by switching channel switching valve 33 to the atmospheric pressure release outlet side and supplying atmospheric pressure to pressure chamber 84 of air cylinder section 58 for pushing, pusher section 55 is raised and the pushing movement is released. Here, atmospheric pressure is also supplied to pressure chamber 76 of air cylinder section 57 for clamping, but clamping claws 51 are held in the clamp release state by the spring force of spring 77 to be prepared for clamp movement for the next component.

After this, by repeating the operations in steps 101 to 106, operation to clamp leads 52 of component 50 and insert them into holes 54 of board 53 is repeated.

In the embodiment described above, the opening amount of clamping claws 51 is set to the minimum amount, or an amount slightly larger than this, such that clamping claws 51 of chuck device 10 do not interfere with adjacent already mounted components during clamp release movement, and by moving chuck device 10 after clamp release movement in a direction away from component 50 in a direction perpendicular to the clamp release movement direction of clamping claws 51, because chuck device 10 is raised after pusher section 55 has been pushed and leads 52 of component 50 have been inserted into holes 54 of board 53 which is done after clamping claws 51 are moved to a retraction position in which clamping claws 51 do not interfere with component 50 during raising, even when mounting a subsequent component 50 with a narrow gap to an already mounted component, it can be avoided that clamping claws 51 interfere with an adjacent already mounted component during clamp release movement; furthermore, because push movement can be performed with the opening amount of clamping claws 51 being small, it can be avoided that clamping claws 51 interfere with an adjacent already mounted component during push movement. By this, mounting can be done with a narrow gap between components and higher density mounting of components (the shrinking of the gaps between components) can be supported.

Also, in the present embodiment, because the lower section of clamping claws 51 of chuck device 10 is formed in an L-shape bent towards pusher section 55, leads 52 of component 50 can be clamped by only moving claw tip section 51a of clamping claws 51 which is bent towards pusher 55 under component 50 during clamp movement, so it is possible to clamp the leads 52 of even relatively small components 50.

Also, in the present embodiment, because the configuration is such that chuck device 10 is held on mounting head 11 of the component mounter such that it can be replaced with a suction nozzle, chuck device 10 can be held on mounting head 11 of the component mounter and used only for production in which chuck device 10 is required, and for production in which chuck device 10 is not required, chuck device 10 can be removed from mounting head 11 of the component mounter and be replaced with a suction nozzle to be used, so the same mounting head 11 can be used efficiently for chuck device 10 and suction nozzles. Furthermore, because the movement of both clamping claws 51 and pusher section 55 by switching the air pressure supplied to the two air cylinder sections 57 and 58 of chuck device 10 can be performed by using the air pressure switching functions (channel switching valve 33 and electromagnetic valve 41) provided on mounting head 11 of the component mounter which are used to switch between the component pickup operation and release operation of suction nozzles, it is not necessary to provide chuck device 10 itself with a dedicated air pressure switching function, which has the merit of making the configuration of chuck device 10 simpler.

Also, with the present embodiment, with respect to the two air cylinder sections 57 and 58 through air supply route 26 of mounting head 11, because the configuration is such that clamping claws 51 are moved in the clamp direction with pusher section 55 held in the push release position when negative pressure is supplied, clamping claws 51 are moved in the clamp release direction when atmospheric pressure is supplied, and pusher section 55 is moved in the push direction when positive pressure is supplied, it is possible to perform push movement of pusher section 55 and clamp movement/release movement of clamping claws 51 by switching the air pressure in the same way as for the component pickup operation/release operation of pickup nozzles, so that the control of each movement of chuck device 10 is also easy.

The applicable scope of the present invention is not limited to component mounters, it can also be applied to component insertion machines, assembly machines and so on.

In addition, it goes without saying that the present invention is not limited to the above embodiment, and various embodiments with changes that do not extend beyond the scope of the invention are possible such as it is acceptable to make suitable changes to the shape of clamping claws 51 and pusher section 55.

### Symbol descriptions

10: Chuck device; 11: Mounting head; 12: Moving mechanism; 13: XY direction moving mechanism; 14: Z direction moving mechanism; 18: Z axis section; 26: Air supply route jointly for positive pressure/atmospheric pressure/negative pressure; 27: Air supply route dedicated for negative pressure; 28: Head rotating device; 33: Channel switching valve; 34: Positive pressure source; 35: Negative pressure source; 41: Electromagnetic valve; 45: Negative pressure chamber for pickup; 50: Component; 51: Clamping claw (clamping section); 51a: Claw tip section; 52: Lead (protrusion); 53: Board (target item); 54: Hole; 55: Pusher section; 57: Air cylinder section for clamping; 58: Air cylinder section for pushing; 61: Arm section; 62: Link member; 63: Raising/lowering member; 67: Piston; 76: Pressure chamber; 77: Spring; 81: Piston; 82: Spring; 84: Pressure chamber; 91: Control device

## Claims

1. A component insertion assembly device equipped with a chuck device (10) for grasping a component (50) and inserting downward facing protrusions (52) of the component (50) into holes (54) in a target item (53);
wherein the chuck device (10) comprises
a clamping section (51) for performing a clamp movement/clamp release movement to the downward facing protrusions (52) of the component (50), and
a pusher section (55) for pushing the downward facing protrusions (52) of the component (50) into the holes (54) in the target item (53); wherein the component insertion assembly device further comprises a moving mechanism (12) for moving the chuck device (10) in the horizontal direction and up/down direction; and
a control device (91) for controlling the push movement of the pusher section (55) and the clamp movement/clamp release movement of the clamping section (51) as well as controlling the moving mechanism (12) to control the movement of the chuck device (10) in the horizontal direction and up/down direction; and
wherein the control device (91), controls in order
i) the clamping section (51) to perform the clamp movement to the downward facing protrusions (52) of the component (50),
ii) the moving mechanism (12) such that the lower end of the protrusions (52) are inserted into holes (54) in the target item (53),
iii) the clamping section (51) to perform the clamp release movement to the downward facing protrusions (52) of the component (50),
iv) the moving mechanism (12) such that the chuck device (10) is moved in a direction away from the component (50), which is a direction perpendicular to the clamp release movement direction of the clamping section (51), to a position that the clamping section (51) does not interfere with the component (50) while the clamping section (51) is raised, and the pusher section (55) is above the component (50),
v) the pusher section (55) to perform a downwards push movement so as to insert the downward facing protrusions (52) of the component (50) further into the holes (54) in the target item (53), and
vi) the moving mechanism (12) such that the chuck device (10) is raised and the clamping section (51) and pusher section (55) are raised to a position higher than the component (50); and
wherein the opening amount during the clamp release movement of the clamping section (51) is set so that interference does not occur with an adjacent already mounted component;
the component insertion assembly device being **characterized by** the chuck device comprising
two air cylinder sections (57, 58) for moving the clamping section (51) and the pusher section (55) respectively; and
a shared air supply entrance for supplying air having negative/atmospheric pressure to a pressure chamber (76) of the air cylinder section (57) for clamping so as to perform the clamp movement/clamp release movement respectively and for supplying air having positive pressure to a pressure chamber (84) of the air cylinder section (58) for pushing so as to perform the downwards push movement; and
wherein the control device (91) further controls the two air cylinder sections (57, 58).

2. The component insertion assembly device according to claim 1 wherein the clamping section (51) is formed in an L-shape with the lower portion thereof bent towards the pusher section side, and the pusher section (55) is positioned in a location separated from the position of the end of the clamping section (51) in a perpendicular direction to the clamp release movement direction of the clamping section (51).

3. A component mounter comprising a component insertion assembly device according to claim 1 or claim 2 applied to the component mounter wherein the chuck device (10) is held on a mounting head (11) provided on the moving mechanism (12) such that the chuck device (10) can be interchanged with a suction nozzle for picking up components (50), and wherein the configuration is such that air pressure is supplied to the two air cylinder sections (57, 58) through an air supply route (26) of the mounting head (11).

## Patentansprüche

1. Eine Komponenteneinführungsvorrichtung bereitgestellt mit einer Spannvorrichtung (10) zum Greifen einer Komponente (50) und zum Einführen von nach unten weisenden Vorsprüngen (52) der Komponente (50) in Löcher (54) in einem Zielgegenstand (53);
wobei die Spannvorrichtung (10) umfasst
einen Klemmabschnitt (51) zum Durchführen einer Klemmbewegung / Klemmlösebewegung zu den nach unten weisenden Vorsprüngen (52) der Komponente (50), und
einen Schieberabschnitt (55) zum Drücken der nach unten weisenden Vorsprünge (52) der Komponente (50) in die Löcher (54) in dem Zielgegenstand (53);
wobei die Komponenteneinführungsvorrichtung ferner umfasst einen Bewegungsmechanismus (12) zum Bewegen der Spannvorrichtung (10) in der horizontalen Richtung und der Aufwärts-/ Abwärtsrichtung; und
eine Steuervorrichtung (91) zum Steuern der Schubbewegung des Schieberabschnitts (55) und der Klemmbewegung / Klemmlösebewegung des Klemmabschnitts (51) sowie zum Steuern des Bewegungsmechanismus (12), um die Bewegung des Spannvorrichtung (10) in horizontaler Richtung und Aufwärts- / Abwärtsrichtung zu steuern; und
wobei die Steuervorrichtung (91) in dieser Reihenfolge steuert
i) den Klemmabschnitt (51) zur Durchführung der Klemmbewegung an den nach unten weisenden Vorsprüngen (52) des Bauteils (50),
ii) den Bewegungsmechanismus (12), so dass das untere Ende der Vorsprünge (52) in Löcher (54) in dem Zielgegenstand (53) eingeführt wird,
iii) den Klemmabschnitt (51), um die Klemmlösebewegung zu den nach unten weisenden Vorsprüngen (52) der Komponente (50) durchzuführen,
iv) den Bewegungsmechanismus (12), so dass die Spannvorrichtung (10) in einer Richtung weg von der Komponente (50) bewegt wird, die eine Richtung ist, die senkrecht zu der Klemmlösebewegungsrichtung des Klemmabschnitts (51) ist, zu einer Position, dass der Klemmabschnitt (51) nicht mit der Komponente (50) interferiert, während der Klemmabschnitt (51) angehoben ist und der Schieberabschnitt (55) über der Komponente (50) ist,
v) den Schieberabschnitt (55), der eine Abwärtsschubbewegung durchführt, um die nach unten weisenden Vorsprünge (52) der Komponente (50) weiter in die Löcher (54) in dem Zielgegenstand (53) einzuführen, und
vi) den Bewegungsmechanismus (12), so dass die Spannvorrichtung (10) angehoben wird und der Klemmabschnitt (51) und der Schieberabschnitt (55) in eine Position angehoben werden, die höher ist als die Komponente (50); und
wobei der Öffnungsbetrag während der Klemmlösebewegung des Klemmabschnitts (51) so eingestellt ist, dass keine Interferenz mit einer bereits montierten benachbarten Komponente auftritt;
wobei die Komponenteneinführungsvorrichtung **dadurch gekennzeichnet ist, dass** die Spannvorrichtung umfasst
zwei Luftzylinderabschnitte (57, 58) zum Bewegen des Klemmabschnitts (51) und des Schieberabschnitts (55); und
einen gemeinsamen Luftzufuhreingang zum Zuführen von Luft mit negativem / atmosphärischem Druck zu einer Druckkammer (76) des Luftzylinderabschnitts (57) zum Klemmen, um jeweils die Klemmbewegung / Klemmlösebewegung durchzuführen und um Luft mit Überdruck zuzuführen, um eine Druckkammer (84) des Luftzylinderabschnitts (58) zu drücken, um die Abwärtsschubbewegung auszuführen; und
wobei die Steuervorrichtung (91) ferner die zwei Luftzylinderabschnitte (57, 58) steuert.

2. Die Komponenteneinführungsvorrichtung nach Anspruch 1, wobei der Klemmabschnitt (51) in einer L-Form ausgebildet ist, wobei der untere Abschnitt davon in Richtung des Schieberabschnitts gebogen ist und der Schieberabschnitt (55) an einer Stelle getrennt von der Position des Endes des Klemmabschnitts (51) positioniert ist, in einer Richtung senkrecht zu der Klemmlösebewegungsrichtung des Klemmabschnitts (51).

3. Ein Komponentenbestücker mit einer Komponenteneinführungsvorrichtung nach Anspruch 1 oder Anspruch 2, die auf den Komponentenbestücker angewendet wird, wobei die Spannvorrichtung (10) an einem Montagekopf (11) gehalten wird, der an dem Bewegungsmechanismus (12) vorgesehen ist, so dass die Spannvorrichtung (10) mit einer Saugdüse zum Aufnehmen von Komponenten (50) ausgetauscht werden kann, und wobei die Anordnung derart ist, dass Luftdruck zu den zwei Luftzylinderabschnitten (57, 58) durch eine Luftzufuhrverbindung (26) des Montagekopfs (11) zugeführt wird.

## Revendications

1. Dispositif d'assemblage d'insertion de composants muni d'un mandrin (10) destiné à saisir un composant (50) et à insérer les protubérances (52) faisant face vers le bas du composant (50) dans des trous (54) pratiqués dans un élément cible (53),
dans lequel le mandrin (10) comprend :
une section de serrage (51) destinée à effectuer un mouvement de serrage ou un mouvement de libération de serrage sur les protubérances (52) faisant face vers le bas du composant (50), et
une section de poussée (55) destinée à pousser les protubérances (52) faisant face vers le bas du composant (50) dans les trous (54) de l'élément cible (53),
le dispositif d'assemblage d'insertion de composants comprenant en outre :
un mécanisme de déplacement (12) destiné à déplacer le mandrin (10) dans la direction horizontale et dans la direction haut bas, et
un dispositif de commande (91) destiné à piloter le mouvement de poussée de la section de poussée (55) et le mouvement de serrage ou de libération de serrage de la section de serrage (51) tout en commandant le mécanisme de déplacement (12) afin de piloter le mouvement du mandrin (10) dans la direction horizontale et dans la direction haut bas, et
dans lequel le dispositif de commande (91) pilote dans l'ordre :
i) la section de serrage (51) afin d'effectuer le mouvement de serrage sur les protubérances (52) faisant face vers le bas du composant (50),
ii) le mécanisme de déplacement (12) de sorte à ce que les extrémités inférieures des protubérances (52) soient insérées dans les trous (54) de l'élément cible (53),
iii) la section de serrage (51) afin d'effectuer le mouvement de libération de serrage sur les protubérances (52) faisant face vers le bas du composant (50),
iv) le mécanisme de déplacement (12) de sorte à ce que le mandrin (10) soit déplacé dans une direction à distance du composant (50), laquelle représente une direction perpendiculaire à la direction de mouvement de libération de serrage de la section de serrage (51), jusqu'à une position telle que la section de serrage (51) n'interfère pas avec le composant (50) lorsque la section de serrage (51) est relevée, et telle que la section de poussée (55) se trouve au-dessus du composant (50),
v) la section de poussée (55) afin d'effectuer un mouvement de poussée vers le bas de sorte à insérer encore plus les protubérances (52) faisant face vers le bas du composant (50) dans les trous (54) de l'élément cible (53), et
vi) le mécanisme de déplacement (12) de sorte à ce que le mandrin (10) soit relevé et que la section de serrage (51) et la section de poussée (55) soient relevées jusqu'à une position plus haute que le composant (50), et
dans lequel la valeur d'ouverture pendant le mouvement de libération de serrage de la section de serrage (51) est réglée de sorte à ce qu'aucune interférence ne se produise avec un composant adjacent déjà monté,
le dispositif d'assemblage d'insertion de composants étant **caractérisé en ce que** le mandrin comprend :
deux sections de vérin pneumatique (57, 58) destinées à déplacer respectivement la section de serrage (51) et la section de poussée (55), et
une entrée de fourniture d'air partagé destinée à fournir de l'air présentant une pression négative par rapport à la pression atmosphérique à une chambre sous pression (76) de la section de vérin pneumatique (57) en vue d'un serrage de sorte à réaliser respectivement le mouvement de serrage ou le mouvement de libération de serrage ; et à fournir de l'air présentant une pression positive à une chambre sous pression (84) de la section de vérin pneumatique (58) en vue d'une poussée de sorte à réaliser le mouvement de poussée vers le bas, et
dans lequel le dispositif de commande (80) pilote en outre les deux sections de vérin pneumatique (57, 58).

2. Dispositif d'assemblage d'insertion de composants selon la revendication 1, dans lequel la section de serrage (51) prend la forme d'un L, sa partie inférieure étant courbée vers le côté de la section de poussée, et où la section de poussée (55) est positionnée dans un emplacement séparé de la position de l'extrémité de la section de serrage (51) dans une direction perpendiculaire à la direction du mouvement de libération de serrage de la section de serrage (51) .

3. Système de montage de composants comprenant un dispositif d'assemblage d'insertion de composants conforme à la revendication 1 ou à la revendication 2, appliqué au système de montage de composants, dans lequel le mandrin (10) est maintenu sur une tête de montage (11) prévue sur le mécanisme de déplacement (12) de sorte à ce que le mandrin (10) puisse être échangé avec une buse d'aspiration destinée à prélever des composants (50), et dans lequel la configuration est telle que la pression d'air est fournie aux deux sections de vérin pneumatique (57, 58) au travers d'une voie d'alimentation en air (26) de la tête de montage (11) .
